# EUROPEAN PATENT SPECIFICATION

(11) **EP 2 747 212 B1**
(45) Date of publication and mention of the grant of the patent: **09.08.2017**
(21) Application number: 12840730.1
(22) Date of filing: 15.03.2012
(51) Int. Cl.: H01R 13/24, H01R 33/76, G01R 1/067

(54) **CONTACTOR**
KONTAKTOR
CONTACTEUR

(30) Priority: 14.10.2011 JP 2011227161
(43) Date of publication of application: 25.06.2014
(73) Proprietor: Omron Corporation, Kyoto-shi, Kyoto 600-8530 (JP)
(72) Inventor: SAKAI, Takahiro, Kyoto-shi Kyoto 600-8530 (JP); HEMMI, Yoshinobu, Kyoto-shi Kyoto 600-8530 (JP)
(74) Representative: Kilian Kilian & Partner
(86) International application number: PCT/JP2012/056655
(87) International publication number: WO 2013/054555

(56) References cited:
- JP-A- S5 537 787
- JP-A- H10 125 428
- JP-A- 2002 008 760
- JP-A- 2003 307 525
- JP-A- 2003 307 525
- JP-A- 2009 128 218
- JP-U- 3 122 168
- US-A- 4 161 346
- US-A1- 2009 111 289
- US-A1- 2009 156 022
- US-B1- 7 150 658

## Description

### TECHNICAL FIELD

The present invention relates to a contactor, and for example, relates to a contactor used for an integrated circuit inspection probe.

### BACKGROUND ART

As a contactor used for an integrated circuit inspection probe, there has hitherto been a contactor of an electronic terminal receptacle, which holds contact between an electrode terminal of an electronic component and an electrode portion of a receptacle body by depressing the electronic component to the receptacle body, and connects the electrode portion of the receptacle body to an electrode terminal of a connected electronic component. The electrode portion of the receptacle main body is formed by performing punching on an elastic plate material with a predetermined thickness, and has at both ends a pair of contacts respectively connected with the electrode terminal of the electronic component and the electrode terminal of the connected electronic component, while having a meandering portion successively installed in parallel and provided between the pair of contacts to connect the pair of contacts (cf. Japanese Unexamined Patent Publication no. 2002-134202). Further prior art documents are US 2009/156022 A1 and JP 2003 307525 A and US-B-7150658. According to US 2009/156022 A1, a contact member is disclosed that includes a trunk part into which a strip-shaped part is formed substantially annularly; a first contact part at a first end of the trunk part; and a second contact part at a second end of the trunk part, the second contact part being positioned inside the first contact part. The first contact part and the second contact part face each other. The strip-shaped part is configured to be elastically twisted to cause the second contact part to come into contact with the first contact part in response to the second contact part being pressed in a direction of the axis of the trunk part. The strip-shaped part includes multiple turn-around parts between the first contact part and the second contact part.

According to JP 2003 307525 A, a contact probe is disclosed that has a plunger part for contacting with an inspection object, a spring part for supporting the plunger part on one end, a lead wire connecting part for electrically connecting the other end of the spring part and a lead wire, and a conducting path part. The plunger part, the spring part, and the conducting path part are integrally formed. The conducting path part is extended up to a position in close vicinity to the plunger part to a degree capable of contacting with the plunger part when the spring part is deformed when the plunger part is pressed. Document US-B-7150658 discloses a contactor comprising: a bellows body, wherein the bellows body is made up of curve-shaped intermediate portions and arc portions each configured to connect the adjacent intermediate portions, wherein each of connecting projections is provided on each boundary between one intermediate portion and one arc portion; a fixed portion, connected to one end of the bellows body and provided with at least one fixed touch piece extending along the bellows body; and a moveable portion, connected to the other end of the bellows body, wherein the moveable portion is adapted to be depressed to compress and buckle the bellows body such that arc portions are brought into contact with a surface of the fixed touch piece of the fixed portion.

### SUMMARY OF THE INVENTION

### PROBLEMS TO BE SOLVED BY THE INVENTION

However, in the contactor of the foregoing electronic terminal receptacle, the number of folding times of the meandering portion is small and a desired shrinkage amount (displacement amount) is thus difficult to ensure, which leads to lowered usability. For this reason, in order to ensure the desired shrinkage amount (displacement amount), there can be considered a long contactor of the electronic terminal receptacle where the number of folding times has been increased. However, when the meandering portion of the long contactor becomes narrow, electric resistance increases to make it difficult for a current to flow and there are thus limits on lengthening of the contactor, which is problematic.

In view of the foregoing problems, an object of present invention is to provide a contactor having desired conductivity while ensuring a predetermined displacement amount. This object is achieved by the subject-matter of claim 1. Further advantageous embodiments of the invention are the subject-matter of the dependent claims. Aspects of the invention are set out below.

An exemplary contactor has: a bellows body; a fixed portion, connected to one end of the bellows body and provided with at least one fixed touch piece extending along the bellows body; and a movable portion, connected to the other end of the bellows body. The contactor has a configuration where the movable portion is depressed to compress the bellows body and bring the movable portion into contact with the fixed touch piece of the fixed portion.

According to the example, even when the bellows body is made long for the purpose of ensuring a desired displacement amount, a short-circuit occurs by contact between the movable portion and the fixed touch piece of the fixed portion, thus making it possible to reduce contact resistance so as to obtain a contactor with small contact resistance.

A contactor according to an aspect of the present invention has: a bellows body; a fixed portion, connected to one end of the bellows body and provided with at least one fixed touch piece extending along the bellows body; and a movable portion, connected to the other end of the bellows body. The contactor has a configuration where the movable portion is depressed to compress the bellows body, while the bellows body is brought into contact with the fixed touch piece of the fixed portion.

### EFFECT OF THE INVENTION

According to the aspect of the present invention, even when the bellows body is made long for the purpose of ensuring a desired displacement amount, a short-circuit occurs by contact between the bellows body and the fixed touch piece of the fixed portion, thus making it possible to reduce contact resistance so as to obtain a contactor with small contact resistance.

According to the present aspect, it is possible to obtain a contactor easy to design.

According to the present invention, connecting projections are provided at adjacent intermediate portions of the bellows body. According to the present invention, it is possible to obtain a contactor with lower contact resistance by occurrence of a short circuit via the connecting projections.

As another aspect of the present invention, the bellows body has a shape made up of curve-shaped intermediate portions and arc portions each configured to connect the adjacent intermediate portions.

As a different aspect of the present invention, connecting projections, configured to come into contact with the intermediate portion and an arc portion, are provided on a boundary therebetween in the bellows body.

According to the present aspect, it is possible to obtain a contactor with lower contact resistance by occurrence of a short circuit via the connecting projection.

As another aspect of the present invention, the fixed touch piece may be extended from each side edge of the fixed portion in parallel along the bellows body.

According to the present aspect, a pair of fixed touch pieces serves as a guide member to stabilize operating characteristics, while the movable portion and the bellows body do not fail to come into contact with any one of the pair of fixed touch pieces, thereby making it possible to obtain a contactor with high contact reliability.

As a different aspect of the present invention, a position of contact between the bellows body and the fixed portion may be arranged on a shaft center of the fixed portion, or the position of contact between the bellows body and the fixed portion may be arranged on an eccentric position from the shaft center of the fixed portion.

According to the present aspect, when the position of contact between the bellows body and the fixed portion is arranged on the shaft center of the fixed portion, there can be obtained a contactor being operable by small force of operation and having a long life.

Meanwhile, when the position of contact between the bellows body and the fixed portion is arranged on an eccentric position from the shaft center of the fixed portion, the bellows body is apt to buckle, and hence it is possible to obtain a contactor with high contact pressure.

As a different aspect of the present invention, a position of contact between the bellows body and the movable portion may be arranged on a shaft center of the movable portion, or the position of contact between the bellows body and the movable portion may be arranged on an eccentric position from the shaft center of the movable portion.

According to the present aspect, when the position of contact between the bellows body and the movable portion is arranged on the shaft center of the movable portion, there can be obtained a contactor being operable by small force of operation and having a long life.

Meanwhile, when the position of contact between the bellows body and the movable portion is arranged on an eccentric position from the shaft center of the movable portion, the bellows body is adapted to buckle, and there is thus an effect of being able to obtain a contactor with high contact pressure.

### BRIEF DESCRIPTION OF THE DRAWINGS

Fig. 1A is a perspective view showing an exemplary contactor and Figs. 1B and 1C are front views respectively showing the contactor before and after an operation.
Fig. 2A is a front view of a state where the contactor shown in Fig. 1 has been housed inside a housing, and Figs. 2B and 2C are front sectional views respectively showing the contactors before and after the operation.
Fig. 3A is a perspective view showing a second example of a contactor and Figs. 3B and 3C are front views respectively showing the contactor before and after the operation; and
Fig. 4A is a front view of a state where the contactor shown in Fig. 3 has been housed inside a housing, and Figs. 4B and 4C are front sectional views respectively showing the contactors before and after the operation.
Fig. 5A is a perspective view showing a third example of a contactor and Figs. 5B and 5C are front views respectively showing the contactor before and after the operation.
Fig. 6A is a front view of a state where the contactor shown in Fig. 5 has been housed inside a housing, and Figs. 6B and 6C are front sectional views respectively showing the contactors before and after the operation.
Fig. 7A is a perspective view showing an embodiment of a contactor according to the present invention, and Figs. 7B and 7C are front views respectively showing the contactor before and after the operation.
Fig. 8A is a front view of a state where the contactor shown in Fig. 5 has been housed inside a housing, and Figs. 8B and 8C are front sectional views respectively showing the contactors before and after the operation.
Figs. 9A, 9B and 9C are front views showing an operating process of the first example,
Fig. 9D is a partially enlarged view of Fig. 9A, Fig. 9E is a partially enlarged view of Fig. 9C, and Fig. 9F is a graph showing results of measurement of the relation between a displacement amount and a contact resistance.
Figs. 10A, 10B and 10C are front views showing an operating process of the embodiment of the invention, and Fig. 10D is a graph showing results of measurement of the relation between a displacement amount and a contact resistance.

### MODE FOR CARRYING OUT THE INVENTION

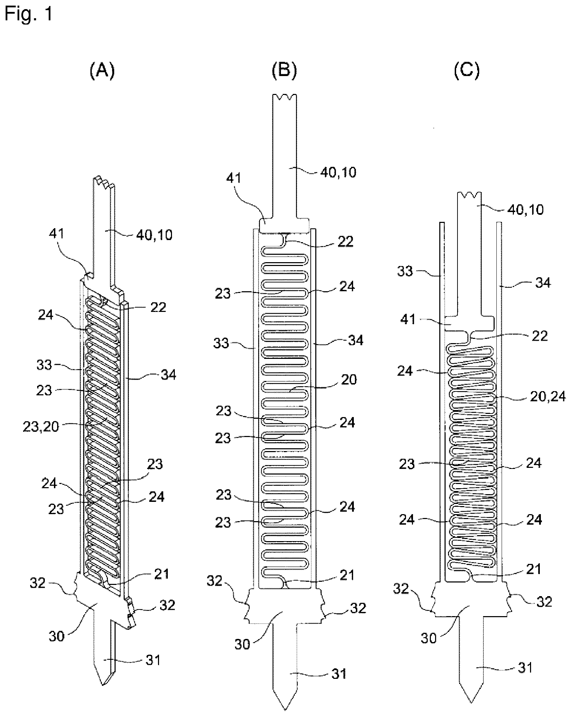

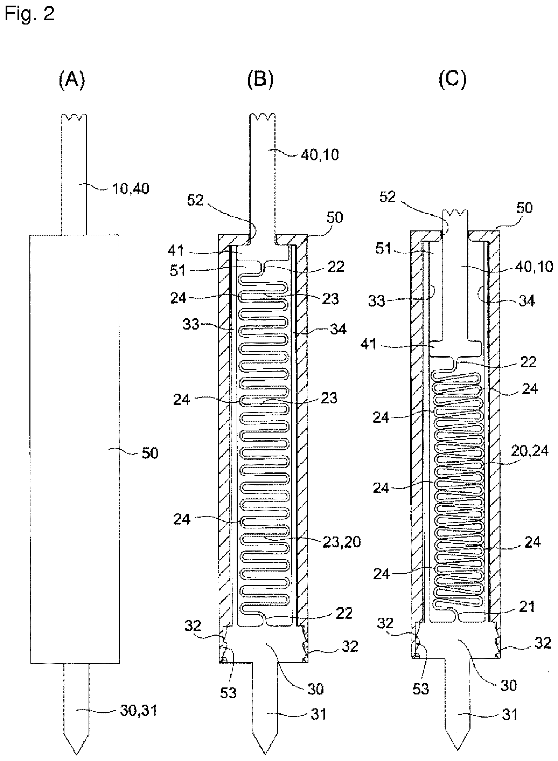

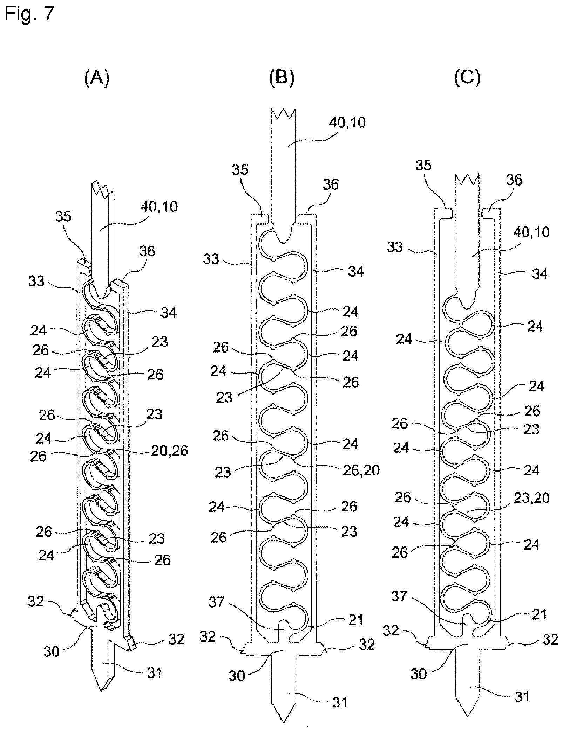

Examples of a contactor will be described in accordance with the accompanying drawings of Figs. 1 to 6 and an embodiment of a contactor according to the present invention will be described in accordance with the accompanying drawing of Figs. 7 to 8. A first example is one in which, as shown in Figs. 1 and 2, a contactor 10 is formed of a bellows body 20, a fixed portion 30 connected to one end 21 of the bellows body 20, and a movable portion 40 connected to the other end 22 of the bellows body 20. The contactor 10 is housed inside a housing 50.

The bellows body 20 is formed of linear-shaped intermediate portions 23 and arc portions 24 each connecting adjacent intermediate portions 23, 23. The bellows body 20 may have a cross section with an aspect ratio being not smaller than 1.5, preferably not smaller than 2, and may be formed by pressing or by electroforming. It is to be noted that the aspect ratio here refers to a ratio of a thickness and a height on the cross section of the bellows body 20.

The one end 21 of the bellows body 20 is connected onto a shaft center of the fixed portion 30 out of the upper end thereof, and a terminal portion 31 is extended at the lower end of the fixed portion 30 along the shaft center. Further, locking claw portions 32 are projectingly provided on both side surfaces of the fixed portion 30, while fixed touch pieces 33, 34 are extended from both side edges of the upper end of the fixed portion 30 in parallel along the bellows body 20.

The movable portion 40 has the front surface in a substantially T-shape, and the other end 22 of the bellows body 20 is connected onto the shaft center out of the lower end of a large width portion 41 of the movable portion 40.

As shown in Fig. 2, the housing 50 has a rectangular-parallelepiped shape having a slit 51 where the contactor 10 can be housed, and the upper end surface of the housing 50 has an operation hole 52, while the lower end surface thereof has a press-fitting hole 53.

As shown in Fig. 2, when the movable portion 40 is pressed down, the bellows body 20 is compressed, and thereby the large width portion 41 slides on the inner side surfaces of the fixed touch pieces 33, 34. Meanwhile, the arc portions 24 come into contact with the fixed touch pieces 33, 34, and the adjacent arc portions 24, 24 come into contact with each other, to cause a short circuit. Hence the contact resistance decreases according to a displacement amount of the movable portion 40, to allow a current to flow.

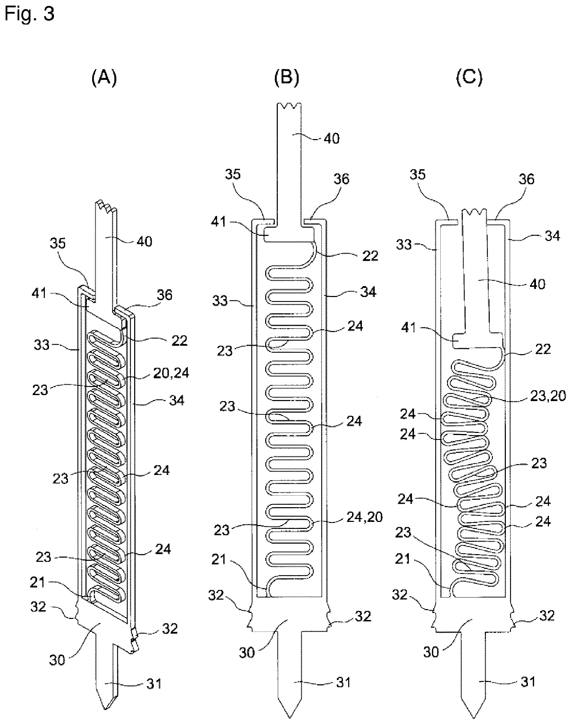

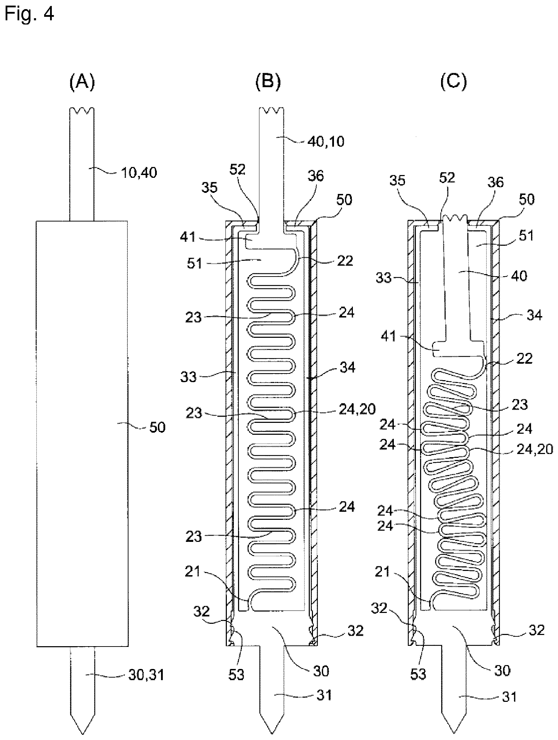

As shown in Figs. 3 and 4, a second example is one as is the foregoing first example, where a contactor 10 is formed of a bellows body 20, a fixed portion 30 connected to one end 21 of the bellows body 20, and a movable portion 40 connected to the other end 22 of the bellows body 20. The contactor 10 is housed inside a housing 50.

The bellows body 20 is formed of linear-shaped intermediate portions 23 and arc portions 24 each connecting adjacent intermediate portions 23, 23.

The one end 21 of the bellows body 20 is connected to an eccentric position from a shaft center of the fixed portion 30 out of the upper end thereof, and a terminal portion 31 is extended at the lower end of the fixed portion 30 along the shaft center. Further, locking claw portions 32 are projectingly provided on both side surfaces of the fixed portion 30, while fixed touch pieces 33, 34 are extended from both side edges of the upper end of the fixed portion 30 in parallel along the bellows body 20. Moreover, the fixed touch pieces 33, 34 are provided with flexing portions 35, 36 formed by flexing the upper ends thereof inward, to prevent slipping-out of the later-mentioned movable portion 40.

The movable portion 40 has the front surface in a substantially T-shape, and the other end 22 of the bellows body 20 is connected to an eccentric position from a shaft center out of the lower end of a large width portion 41 of the movable portion 40.

As shown in Fig. 4, the housing 50 has a rectangular-parallelepiped shape having a slit 51 where the contactor 10 can be housed, and the upper end surface of the housing 50 has an operation hole 52, while the lower end surface thereof has a press-fitting hole 53.

When the movable portion 40 is pressed down, the bellows body 20 is compressed and also buckles, and thereby one side of the large width portion 41 comes into contact with the inner side surface of the fixed touch piece 34. In the meantime, the adjacent arc portions 24, 24 come into contact with each other, while coming into contact with the inner side surfaces of the fixed touch pieces 33, 34, to cause a short circuit. Hence the contact resistance decreases according to a displacement amount of the movable portion 40, to allow a current to flow.

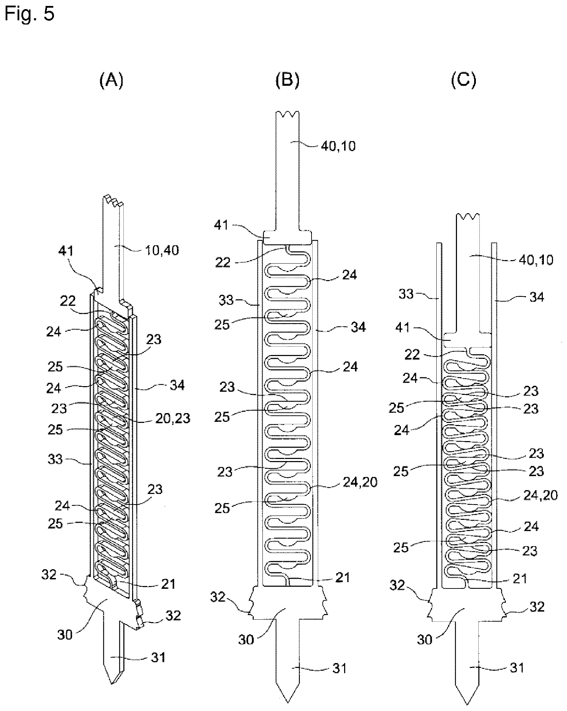

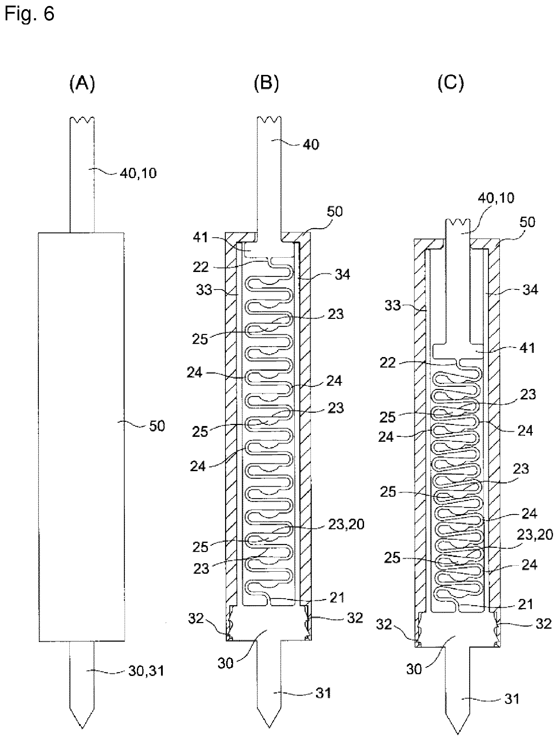

As shown in Figs. 5 and 6, a third example is one almost the same as the foregoing first example, where a contactor 10 is formed of a bellows body 20, a fixed portion 30 connected to one end 21 of the bellows body 20, and a movable portion 40 connected to the other end 22 of the bellows body 20. The contactor 10 is housed inside a housing 50.

The third example is different from the first example in that a connecting projection 25 is provided in one of the adjacent intermediate portions 23 of the bellows body 20. Since the others are the same as those in the first example, the same portion is provided with the same numeral and a description thereof will be omitted.

According to the present example, as shown in Fig. 6, when the movable portion 40 is pressed down, the bellows body 20 is compressed, and thereby the large width portion 41 slides on the inner side surface of either the fixed touch pieces 33 or 34. In the meantime, the connecting projection 25 ofthe bellows body 20 comes into contact with the intermediate portion 23 opposed thereto, while the adjacent arc portion 24 comes into contact with either the fixed touch pieces 33 or 34, to cause a short circuit, whereby the contact resistance decreases and a current flows.

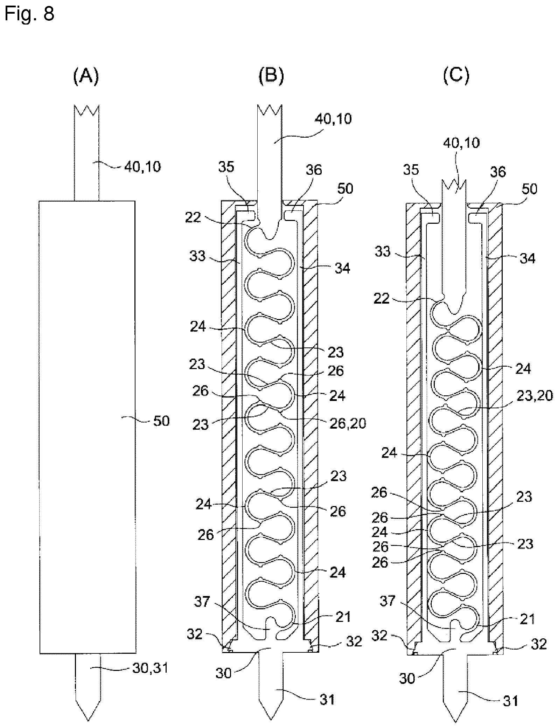

As shown in Figs. 7 and 8, the embodiment of the invention is one almost the same as the foregoing first example, where a contactor 10 is formed of a bellows body 20, a fixed portion 30 connected to one end 21 of the bellows body 20, and a movable portion 40 connected to the other end 22 of the bellows body 20. The contactor 10 is housed inside a housing 50.

The bellows body 20 is formed of curve-shaped intermediate portions 23, and arc portions 24 each connecting adjacent intermediate portions 23. Then each of connecting projections 26, which can come into contact with each other, is provided on each boundary between the intermediate portion 23 and the arc portion 24.

The one end 21 of the bellows body 20 is connected to a contacting shaft portion 37 projectingly provided on a shaft center of the fixed portion 30 out of the upper end thereof, and a terminal portion 31 is extended at the lower end of the fixed portion 30 along the shaft center. Further, locking claw portions 32 are projectingly provided on both side surfaces of the fixed portion 30, while fixed touch pieces 33, 34 are extended from both side edges of the upper end of the fixed portion 30 in parallel along the bellows body 20. Moreover, the fixed touch pieces 33, 34 are provided with flexing portions 35, 36 formed by flexing the upper ends thereof inward, to prevent slipping-out of the later-mentioned bellows body 20.

The movable portion 40 has the front surface in a substantially I-shape, and the other end 22 of the bellows body 20 is connected to an eccentric position from a shaft center of the lower end of the movable portion 40.

As shown in Fig. 8, the housing 50 has a rectangular-parallelepiped shape having a slit 51 where the contactor 10 can be housed, and the upper end surface of the housing 50 has an operation hole 52, while the lower end surface thereof has a press-fitting hole 53.

According to the present embodiment, as shown in Fig. 8, when the movable portion 40 is pressed down, the bellows body 20 is compressed and buckles, and thereby the arc portions 24 comes into contact with the inner side surfaces of the fixed touch pieces 33, 34, while the adjacent connecting projections 26 of the bellows body 20 come into contact with each other, to cause a short circuit, whereby the contact resistance decreases and a current flows.

### Example 1

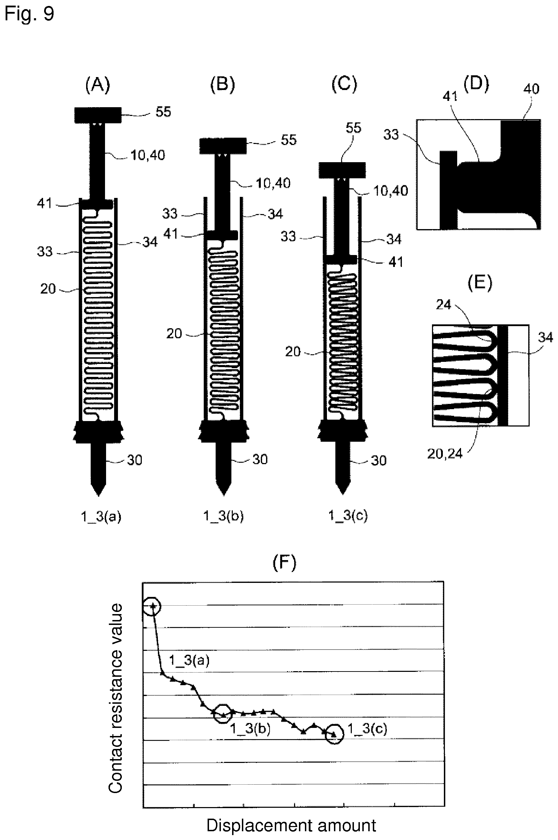

The relation between the displacement amount and the contact resistance value of the contactor according to the first example was measured. Fig. 9F graphically shows a result of the measurement.

As apparent from Fig. 9F, before the operation (Fig. 9A), the contact resistance value is extremely large, and a current hardly flows.

When an operation body 55 of the movable portion 40 is pressed down, the large width portion 41 of the movable portion 40 comes into contact with the inner side surfaces of the fixed touch pieces 33, 34 (Figs. 9A, 9D), the contact resistance values abruptly decreases, and a current starts to flow.

Further, when the movable portion 40 is pressed down (Figs. 9B, 9C), the adjacent arc portions 24 of the bellows body 20 come into contact with each other to cause a short circuit, while coming into contact with the fixed touch piece 34 (Fig. 9E). Hence the contact resistance gradually decreases, and a current stably flows.

From the foregoing example 1, it was found that the above contactor is not only usable as an integrated circuit inspection probe, but also usable as a switch, for example.

Especially when it is used as the integrated circuit inspection probe, since the above contactor can be formed with a small thickness, it is possible to arrange a large number of contactors at narrow pitches, while obtaining an integrated circuit inspection probe with a small number of components. Further, when it is used as the switch, a switch with good responsiveness can be obtained.

### Example 2

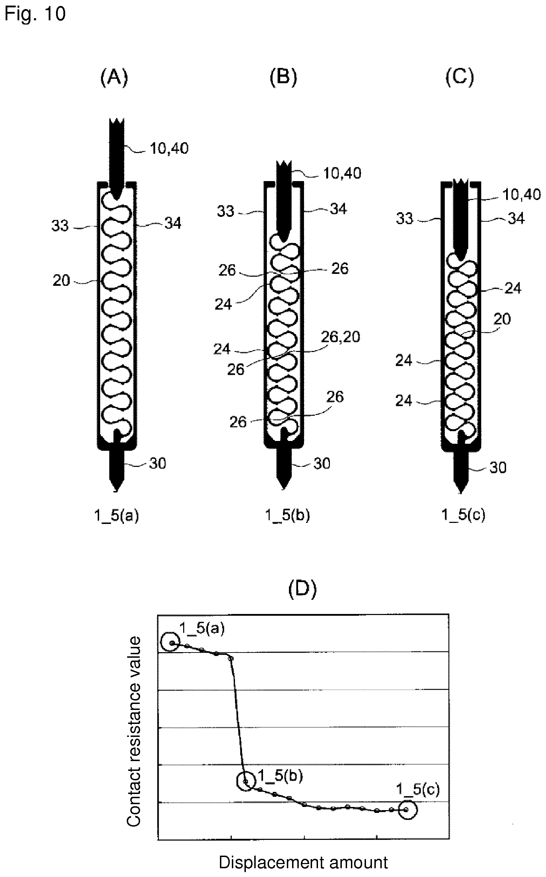

The relation between the displacement amount and the contact resistance value of the contactor according to the embodiment according to the invention was measured. Fig. 10D graphically shows a result of the measurement.

As apparent from Fig. 10D, before the operation (Fig. 10A), the contact resistance value is extremely large, and a current hardly flows.

Even when the movable portion 40 is pressed down, the contact resistance value does not abruptly decrease until a predetermined displacement amount is reached. However, when the predetermined displacement amount is reached (Fig. 10B), a buckling amount rapidly increases, and thereby the arc portion 24 of the bellows body 20 comes into contact with the inner side surfaces of the fixed touch pieces 33, 34, to cause a short circuit. Hence the contact resistance value abruptly decreases, and a current starts to flow.

Further, when the movable portion is pressed down (Fig. 10C), the adjacent connecting projections 26 of the bellows body 20 come into contact with each other to cause a short circuit, and thereby the contact resistance gradually decreases and a current stably flows.

From the foregoing example 2, it was found that the above contactor is not only usable as an integrated circuit inspection probe, but also usable as a switch.

Especially when it is used as the integrated circuit inspection probe, since the above contactor can be formed with a small thickness, it is possible to arrange a large number of contactors at narrow pitches, while obtaining an integrated circuit inspection probe with a small number of components. Further, when it is used as the switch, since a current starts to flow after pressing-down in a predetermined amount, it is possible to obtain a switch with different operating characteristics from those of the first embodiment.

### INDUSTRIAL APPLICABILITY

The contactor according to the present invention is not only usable as an integrated circuit inspection probe or a switch, but may also be used as a contact terminal of a battery.

Needless to say, the housing is not restricted to an integrally molded one, but may be one dividable into two parts.

### DESCRIPTION OF SYMBOLS

- 10: contactor
- 20: bellows body
- 21: one end
- 22: other end
- 23: intermediate portion
- 24: arc portion
- 25: connecting projection
- 26: connecting projection
- 30: fixed portion
- 31: terminal portion
- 32: locking claw portion
- 33, 34: fixed touch piece
- 35, 36: flexing portion
- 37: connecting shaft portion
- 40: movable portion
- 41: large width portion
- 50: housing
- 51: slit
- 52: operation hole
- 53: press-fitting hole

## Claims

1. A contactor (10) comprising:
a bellows body (20), wherein the bellows body (20) is made up of curve-shaped intermediate portions (23) and arc portions (24) each configured to connect the adjacent intermediate portions (23), wherein each of connecting projections (26) is provided on each boundary between one intermediate portion (23) and one arc portion (24) such that adjacent connection projections (26) come into contact with each other upon compression of the bellows body;
a fixed portion (30), connected to one end (21) of the bellows body (20) and provided with at least one fixed touch piece (33, 34) extending along the bellows body (20); and
a movable portion (40), connected to the other end (22) of the bellows body (20),
wherein the moveable portion (40) is adapted to be depressed to compress and buckle the bellows body (20) such that arc portions (24) are brought into contact with an inner side surface of the fixed touch piece (33, 34) of the fixed portion (30), while adjacent connecting projections (26) of the bellows body (20) come into contact with each other.

2. The contactor (10) according to claim 1, wherein the fixed touch piece (33, 34) is extended from each side edge of the fixed portion (30) in parallel along the bellows body (20).

3. The contactor (10) according to claim 1 or 2, wherein a position of contact between the bellows body (20) and the fixed portion (30) is arranged on a shaft center of the fixed portion (30).

4. The contactor (10) according to claim 1 or 2, wherein a position of contact between the bellows body (20) and the fixed portion (30) is arranged on an eccentric position from a shaft center of the fixed portion (30).

5. The contactor (10) according to any one of claims 1 to 4, wherein a position of contact between the bellows body (20) and the movable portion (40) is arranged on a shaft center of the movable portion (30).

6. The contactor (10) according to any one of claims 1 to 4, wherein a position of contact between the bellows body (20) and the movable portion (40) is arranged on an eccentric position from a shaft center of the movable portion (40).

## Patentansprüche

1. Kontaktiervorrichtung (10), umfassend:
einen Balgkörper (20), wobei der Balgkörper (20) aufgebaut ist aus kurvenförmigen Zwischenabschnitten (23) und Bogenabschnitten (24), die jeweils eingerichtet sind, die angrenzenden Zwischenabschnitte (23) zu verbinden, wobei jeder von
Verbindungsvorsprüngen (26) an jeder Grenze zwischen einem Zwischenabschnitt (23) und einem Bogenabschnitt (24) derart bereitgestellt ist, dass bei Komprimierung des Balgkörpers angrenzende Verbindungsvorsprünge (26) miteinander in Kontakt kommen,
einen feststehenden Abschnitt (30), der mit einem Ende (21) des Balgkörpers (20) verbunden und mit mindestens einem feststehenden Berührungsstück (33, 34) versehen ist, das sich entlang des Balgkörpers (20) erstreckt, und
einen bewegbaren Abschnitt (40), der mit dem anderen Ende (22) des Balgkörpers (20) verbunden ist,
wobei der bewegbare Abschnitt (40) angepasst ist, eingedrückt zu werden, um den Balgkörper (20) derart zu komprimieren und zu krümmen, dass Bogenabschnitte (24) mit einer inneren Seitenfläche des feststehenden Berührungsstücks (33, 34) des feststehenden Abschnitts (30) in Kontakt gebracht werden, während angrenzende Verbindungsvorsprünge (26) des Balgkörpers (20) miteinander in Kontakt kommen.

2. Kontaktiervorrichtung (10) nach Anspruch 1, wobei das feststehende Berührungsstück (33, 34) von jeder Seitenkante des feststehenden Abschnitts (30) parallel entlang des Balgkörpers (20) erstreckt ist.

3. Kontaktiervorrichtung (10) nach Anspruch 1 oder 2, wobei eine Kontaktposition zwischen dem Balgkörper (20) und dem feststehenden Abschnitt (30) auf einer Wellenmitte des feststehenden Abschnitts (30) angeordnet ist.

4. Kontaktiervorrichtung (10) nach Anspruch 1 oder 2, wobei eine Kontaktposition zwischen dem Balgkörper (20) und dem feststehenden Abschnitt (30) auf einer zu einer Wellenmitte des feststehenden Abschnitts (30) exzentrischen Position angeordnet ist.

5. Kontaktiervorrichtung (10) nach einem der Ansprüche 1 bis 4, wobei eine Kontaktposition zwischen dem Balgkörper (20) und dem bewegbaren Abschnitt (40) auf einer Wellenmitte des bewegbaren Abschnitts (30) angeordnet ist.

6. Kontaktiervorrichtung (10) nach einem der Ansprüche 1 bis 4, wobei eine Kontaktposition zwischen dem Balgkörper (20) und dem bewegbaren Abschnitt (40) auf einer zu einer Wellenmitte des bewegbaren Abschnitts (40) exzentrischen Position angeordnet ist.

## Revendications

1. Contacteur (10) comprenant :
un corps de soufflet (20), dans lequel le corps de soufflet (20) est constitué de portions intermédiaires de forme incurvée (23) et de portions en arc (24) configurées chacune pour raccorder les portions intermédiaires (23) adjacentes, dans lequel chacune de protubérances de raccordement (26) est prévue sur chaque limite entre une portion intermédiaire (23) et une portion en arc (24), de sorte que des protubérances de raccordement (26) adjacentes viennent en contact les unes avec les autres lors de la compression du corps de soufflet ;
une portion fixe (30), raccordée à une extrémité (21) du corps de soufflet (20) et pourvue d'au moins une pièce de contact fixe (33, 34) s'étendant le long du corps de soufflet (20) ; et
une portion mobile (40), raccordée à l'autre extrémité (22) du corps de soufflet (20),
dans lequel la portion mobile (40) est adaptée pour être enfoncée afin de comprimer et de fléchir le corps de soufflet (20), de sorte que les portions en arc (24) soient mises en contact avec une surface latérale interne de la pièce de contact fixe (33, 34) de la portion fixe (30), tandis que des protubérances de raccordement (26) adjacentes du corps de soufflet (20) viennent en contact les unes avec les autres.

2. Contacteur (10) selon la revendication 1, dans lequel la pièce de contact fixe (33, 34) s'étend à partir de chaque bord latéral de la portion fixe (30) parallèlement le long du corps de soufflet (20).

3. Contacteur (10) selon la revendication 1 ou 2, dans lequel une position de contact entre le corps de soufflet (20) et la portion fixe (30) est agencée sur un centre d'arbre de la portion fixe (30).

4. Contacteur (10) selon la revendication 1 ou 2, dans lequel une position de contact entre le corps de soufflet (20) et la portion fixe (30) est agencée sur une position excentrique à partir d'un centre d'arbre de la portion fixe (30).

5. Contacteur (10) selon l'une quelconque des revendications 1 à 4, dans lequel une position de contact entre le corps de soufflet (20) et la portion mobile (40) est agencée sur un centre d'arbre de la portion mobile (30).

6. Contacteur (10) selon l'une quelconque des revendications 1 à 4, dans lequel une position de contact entre le corps de soufflet (20) et la portion mobile (40) est agencée sur une position excentrique à partir d'un centre d'arbre de la portion mobile (40).
